# EUROPÄISCHE PATENTSCHRIFT

(11) **EP 3 641 133 B1**
(45) Veröffentlichungstag und Bekanntmachung des Hinweises auf die Patenterteilung: **11.09.2024**
(21) Anmeldenummer: 18201020.7
(22) Anmeldetag: 17.10.2018
(51) Int. Cl.: H03K 17/0412

(54) **TREIBERVORRICHTUNG**
DRIVER DEVICE
DISPOSITIF PILOTE

(43) Veröffentlichungstag der Anmeldung: 22.04.2020
(73) Patentinhaber: Siemens Healthineers AG, 91301 Forchheim (DE)
(72) Erfinder: Graba, Rainer, 91056 Erlangen (DE); Hergt, Martin, 90411 Nürnberg (DE); Hiller, Marc, 75015 Bretten (DE)
(74) Vertreter: Siemens Healthineers Patent Attorneys

(56) Entgegenhaltungen:
- EP-A2- 1 005 160
- US-A- 4 641 378
- US-A- 5 825 218
- US-B1- 6 320 414
- BASTIAN VOGLER ET AL: "Integration of 1200V SOI gate driver ICs into a medium power IGBT module package", POWER SEMICONDUCTOR DEVICES&IC'S (ISPSD), 2010 22ND INTERNATIONAL SYMPOSIUM ON, IEEE, PISCATAWAY, NJ, USA, 6 June 2010 (2010-06-06), pages 97 - 100, XP031730068, ISBN: 978-1-4244-7718-0

## Beschreibung

Die Erfindung betrifft eine Treibervorrichtung zur Leistungsschaltung, insbesondere für hohe Frequenzbereiche, und eine entsprechende Schaltvorrichtung zur Leistungsschaltung. Neuartige Leistungsschaltungen, z.B. Leistungsschaltungen mit Feldeffekttransistoren (FETs) auf der Basis von Galliumnitrid (GaN) oder Siliziumcarbid (SiC) haben die Eigenschaft, dass sie theoretisch in einem erheblich höheren Frequenzbereich betrieben werden können als bisherige Leistungsschaltungen, z.B. basierend auf normalen Si-FETs oder Bipolartransistoren mit isolierter Gate-Elektrode (kurz "IGBT" aus dem englischen "Insulated-Gate Bipolar Transistor").

Diese theoretisch erreichbaren hohen Frequenzen können jedoch nur erreicht werden, wenn auch eine entsprechende Treibervorrichtung zur Verfügung steht. Nach dem heutigen Stand der Technik können mit integrierten Treibern typischerweise Taktfrequenzen bis hin zu einigen 10 MHz erreicht werden. Nachteil des Standes der Technik ist, dass sich höhere Frequenzen, z.B. Frequenzen im hohen zweistelligen MHz-Bereich oder höher, bisher nicht erreicht werden können oder nur mit einem hohen Aufwand und unerwünschten Nebenerscheinungen, z.B. Laufzeitdifferenzen, die zu einer asymmetrischen Stromverteilung führen können.

Es ist eine Aufgabe der vorliegenden Erfindung, eine verbesserte Treibervorrichtung bzw. Leistungsschaltung zur Verfügung zu stellen, mit der die oben beschriebenen Nachteile vermieden werden.

Diese Aufgabe wird durch eine Treibervorrichtung gemäß Patentanspruch 1, ein Herstellungsverfahren gemäß Patentanspruch 8, eine Schaltvorrichtung gemäß Patentanspruch 9 sowie durch ein Schaltverfahren gemäß Patentanspruch 11 gelöst.

Die erfindungsgemäße Treibervorrichtung bzw. die erfindungsgemäße Schaltvorrichtung dienen bestimmungsgemäß zur Schaltung einer Leistung. Dies bedeutet, dass das technische Feld der Erfindung im Bereich der Leistungselektronik angesiedelt ist. Größenordnungen für die Spannung sind einige 100 V, z.B. 650 V für einen geschalteten GaN-FET. Stromstärken können bei einigen 10 A liegen, z.B. bei 90 A. Die Erfindung dient insbesondere zur Schaltung hoher Frequenzen. Bedingt für die Topologie des Treibers können Schaltfrequenzen im hohen zweistelligen MHz-Bereich oder darüber (100 MHz oder mehr) erreicht werden.

Eine erfindungsgemäße Treibervorrichtung dient bestimmungsgemäß zur Schaltung eines Leistungsschalters. In dem Falle, dass der Leistungsschalter ein Feldeffekttransistor ist, kann die Treibervorrichtung auch als "Gate-Treiber" bezeichnet werden, da sie auf das Gate des Feldeffekttransistors wirkt.

Die Treibervorrichtung umfasst die folgenden Komponenten.
- eine Signalschnittstelle ausgelegt für den Empfang eines Eingangssignals. Dieses Eingangssignal kann zwar theoretisch mittels eines Signalerzeugers innerhalb der Treibervorrichtung erzeugt werden, wobei die Signalschnittstelle in diesem Falle lediglich eine elektrisch leitfähige Verbindung mit dem Signalgeber darstellen würde, bevorzugt ist jedoch, dass das Eingangssignal von außen appliziert wird und die Signalschnittstelle eine elektrisch leitfähige Anschlussmöglichkeit darstellt, z.B. einen Stecker, eine Buchse, eine Klemme, Lötkontakte oder eine sonstige elektrisch leifähige Verbindung. Es sei an dieser Stelle angemerkt, dass im Folgenden der Ausdruck "verbunden" stets eine elektrisch leitfähige Verbindung einschließt. Auch wenn lediglich eine einzige Verbindung benötigt wird, ist stets impliziert, dass in dem Falle in dem die Bezugspotentiale nicht eindeutig festgelegt sind, bevorzugt zwei elektrisch leitfähige Verbindungen vorhanden sind, von denen eine die Bezugspotentiale verbindet. Im Falle des Eingangssignals hat die Signalschnittstelle z.B. zwei elektrisch leitfähige Verbindungspunkte, eine für den Signaleingang relevante und eine zur Definition des Bezugspotentials, z.B. mit GND (Ground). Es ist in diesem Sinne selbstverständlich, dass eine Reihenschaltung von Komponenten auch die Verbindung der Bezugspotentiale mit einschließen sollte.
- Eine Ausgangsschnittstelle ausgelegt für eine elektrisch leitfähige Verbindung mit dem Schalteingang eines Leistungsschalters. Hier gilt entsprechendes wie für die Signalschnittstelle. Die Ausgangsschnittstelle ist mit einem Schalteingang eines Leistungsschalters, z.B. dem Gate eines Leistungstransistors, elektrisch leitend verbindbar.
- Eine Kaskodenschaltung

Diese Kaskodenschaltung umfasst eine Emitterstufe und eine Basisstufe. Der grundsätzliche Aufbau einer Kaskodenschaltung (oder kurz: "Kaskode") ist dem Fachmann bekannt und umfasst eine Emitterschaltung als Eingangsschaltung und eine Basisschaltung als Ausgangsschaltung.

Im Falle der Erfindung ist ein Aufbau aus Feldeffekttransistoren (FETs) bevorzugt. Auch wenn ein Aufbau aus FETs bevorzugt ist, bei denen der Source-Anschluss dem Emitter eines Bipolartransistor entspricht, wird aus Gründen der besseren Verständlichkeit im Folgenden die gebräuchlichen Bezeichnungen "Emitterstufe" (Für die Emitterschaltung) und "Basisstufe" (Für die Basisschaltung) verwendet. Im Falle einer Verwendung von Feldeffekttransistoren wäre die Emitterschaltung eine Sourceschaltung und die Basisschaltung eine Gateschaltung, was in den (seltener verwendeten) Begriffen "Sourcestufe" und "Gatestufe" resultieren würde, die anstelle der Begriffe "Emitterstufe" und "Basisstufe" verwendet werden könnten. Die Transistoren sollten über eine ausreichend hohe Transitfrequenz verfügen.

Die Kaskode könnte theoretisch auch mit Röhren oder Operationsverstärkern realisiert werden, jedoch müssten die Bauteile bei den angestrebten hohen Frequenzen störungsfrei arbeiten. Insbesondere bei der Verwendung von Operationsverstärkern müssen diese für eine ausreichende Treiberleistung ausgelegt sein und die Bandbreite muss für die hohen Frequenzen ausgelegt sein. Im Falle von Elektronenröhren könnten die Stufen mit "Kathodenbasisstufe" und "Gitterbasisstufe" bezeichnet werden.

Die Emitterstufe der Kaskodenschaltung ist mit der Signalschnittstelle verschaltet und deren Basisstufe mit der Ausgangsschnittstelle. Im Falle einer Verwendung von FETs wäre das Gate des FET der Emitterstufe mit der Signalschnittstelle verbunden (und das Bezugspotential der Signalschnittstelle, ggf. über einen Widerstand mit dem Source-Anschluss des FET). Bezüglich der Ausgangsschnittstelle wäre Drain des FET der Basisstufe mit der Ausgangsschnittstelle verbunden (und das Bezugspotential der Ausgangsschnittstelle, ggf. über einen Widerstand mit dem Gate des FET, wobei der Widerstand Teil eines Spannungsteilers sein kann).

Es liegt also eine Reihenschaltung Signalschnittstelle - Kaskodenschaltung - Ausgangsschnittstelle vor, so dass ein Eingangssignal in die Emitterstufe der Kaskodenschaltung eingeht und (ggf. verstärkt) and die Ausgangsschnittstelle weitergegeben wird.

Durch die geringe Eingangsimpedanz der Basisstufe wird der Miller-Effekt weitgehend reduziert. Bedingt durch die zu vernachlässigende Rückwirkung der Schaltung, können Frequenzen bis zu einigen GHz erreicht werden.

Ein erfindungsgemäßes Herstellungsverfahren zur Herstellung einer erfindungsgemäßen Treibervorrichtung umfasst die folgenden Schritte.
- Bereitstellung einer Signalschnittstelle ausgelegt für eine elektrisch leitfähige Verbindung mit einem Eingangssignal.
- Bereitstellung einer Ausgangsschnittstelle ausgelegt für eine elektrisch leitfähige Verbindung mit einem Schalteingang eines Leistungsschalters.
- Anordnung einer Kaskodenschaltung mit einer Emitterstufe und einer Basisstufe, deren Emitterstufe mit der Signalschnittstelle verschaltet ist, und deren Basisstufe mit der Ausgangsschnittstelle verschaltet ist.
- Leistungsanpassung der Emitterstufe. Dazu wird bevorzugt eine Anpassung über ein Anpassnetzwerk bzw. eine Anpassung im Hinblick auf die gewünschten Schaltfrequenz vorgenommen.

Eine erfindungsgemäße Schaltvorrichtung zur Leistungsschaltung umfasst einen Leistungsschalter und eine erfindungsgemäße Treibervorrichtung, wobei der Leistungsschalter mit seinem Schalteingang mit der Ausgangsschnittstelle der Treibervorrichtung verbunden ist.

In dem bevorzugten Fall, dass als Leistungsschalter Leistungstransistoren eingesetzt werden, ist der Schalteingang das Gate eines Feldeffekttransistors (FET).

Ein erfindungsgemäßes Schaltverfahren zur Leistungsschaltung mittels einer erfindungsgemäßen Schaltvorrichtung umfasst die folgenden Schritte.
- Anlegen einer Schaltspannung an einen Spannungseingang des Leistungsschalters. Im Falle eines Feldeffekttransistors wäre dies der Drain-Anschluss. Typische Spannungen für GaN-FETs und SiC-FETs liegen in dem Bereich um 600 V bzw. 1200V.
- Anlegen einer Treiberspannung an die Treibervorrichtung. Die typischen Spannungen liegen dabei im Bereich von einigen Volt für die Eingangsspannung des Eingangssignals (bevorzugt im TTL Bereich: 0 bis 5V), und für die Versorgungsspannung des Treibers (Treiberspannung) im Bereich der Steuerspannung (für einen FET die Gate-Spannung) des Leistungsschalters.

In einem bevorzugten Fall wird die Schaltung (Treibervorrichtung) mit positiver und negativer Spannung betrieben, um den Leistungsschalter optimal ansteuern zu können. Das Bezugspotential der Treibervorrichtung ist das Source-Potential des Leistungsschalters.
- Applikation eines Eingangssignals an der Signalschnittstelle der Treibervorrichtung mit einer Frequenz von 5 MHz oder größer, insbesondere größer als 20MHz oder gar größer als 50 MHz.

Vorteil der Erfindung ist, dass bei der erfindungsgemäßen Ausführung der Treibervorrichtung diese bedingt durch ihre besondere Topologie bis zu sehr hohen Schaltfrequenzen, z.B. 50 MHz aber auch bedeutend höher betrieben werden kann und somit zur Ansteuerung von GaN- und SiC-Transistoren sehr gut geeignet ist. Dabei spielt die Topologie des Treibers eine entscheidende Rolle, die in Form einer Kaskodenschaltung realisiert ist. Die Kaskodenschaltung kann aufgrund ihres Aufbaus bis zu sehr hohen Schaltfrequenzen betrieben werden.

Die Treibervorrichtung umfasst einen Spannungsregulator. Dieser Spannungsregulator ist dazu ausgestaltet, die Kaskodenschaltung im linearen Bereich zu betreiben. Dazu wird der Arbeitspunkt der Basisstufe und/oder der Emitterstufe entsprechend eingestellt. Diese Spannung wird mittels eine Spannungsteilers eingestellt. Im bevorzugten Falle der Verwendung von FETs in der Kaskodenschaltung wird das Gate des betreffenden FET der Basisstufe und/oder Emitterstufe der Kaskode mit einer bestimmten Spannung betrieben, die durch die Spezifikation des FET festgelegt sind.

Durch einen geeigneten Arbeitspunkt im linearen Bereich wird sichergestellt, dass der Transistor in der Emitterschaltung bzw. Basisschaltung im linearen Bereich betrieben wird. Die Emitterstufe ist für die Stromverstärkung zuständig und kann entsprechend dem Leistungstransistortyp angepasst werden. Die Basisstufe ist für die Spannungsverstärkung verantwortlich. Bevorzugt umfasst die Treibervorrichtung eine Spannungsversorgung oder zumindest einen Anschluss für eine Spannungsversorgung zur Definition der Treiberspannung. Die Spannungsversorgung, die auch als "Bias-Netzwerk" bezeichnet werden kann, dient zur Bereitstellung der Versorgungsspannung der Kaskodenschaltung.

Gemäß einer bevorzugten Treibervorrichtung ist die Signalschnittstelle mittels einer Isolatoreinheit mit der Kaskodenschaltung verbunden. Die Isolatoreinheit ist dabei zu einer galvanischen Trennung der Signalschnittstelle und der Kaskodenschaltung ausgelegt. Der Begriff "Isolator" bezieht sich also auf die galvanische Trennung. Bevorzugt umfasst die Isolatoreinheit einen kapazitiven Koppler, einen Optokoppler oder einen Transformator. Die Art und Bauweise der Isolatoreinheit sollte an die bestimmungsgemäß anliegenden Signale angepasst sein, insbesondere im Hinblick auf den Frequenzbereich. Vorteil der Isolatoreinheit ist eine galvanischen Trennung vom Erzeuger des Eingangssignals und eine damit verbundene Vermeidung von Gleichtaktsignalen. Die Isolatoreinheit kann auch als Signalschnittstelle fungieren.

Gemäß einer bevorzugten Treibervorrichtung ist zwischen Signalschnittstelle und Kaskodenschaltung und/oder zwischen Kaskodenschaltung und Ausgangsschnittstelle ein (breitbandiges) Anpassnetzwerk angeordnet. Dieses ist zur Anpassung von Impedanzen zwischen der Kaskodenschaltung und der betreffenden Schnittstelle (Signalschnittstelle bzw. Ausgangsschnittstelle) ausgelegt. Das Anpassnetzwerk kann auch als Signalschnittstelle bzw. Ausgangsschnittstelle fungieren.

Stand der Technik ist eine breitbandige Anpassung mit Hilfe eines Widerstandes oder einer Anordnung mehrerer Widerstände. Bei Frequenzen im MHz Bereich oder darüber entstehen durch eine solche Anordnung jedoch oftmals störende Reflexionen und Wanderwellen auf den Leitungen der Schaltung. Daher ist als Anpassnetzwerk eine Reaktanz (Blindwiderstand) bevorzugt, welche den Vorteil hat, dass sie die Reflexionen effektiv reduzieren und Spannungsspitzen an der Ausgangsschnittstelle vermeiden kann. Es ist bevorzugt, die Reaktanz auf ein spezielles Pulsmuster auszulegen, welches abhängig von dem bestimmungsgemäß applizierten Eingangssignal ist.

Es ist ein sehr breitbandiges Anpassnetzwerk bevorzugt. Der Ausdruck "breitbandig" umfasst hier einen Frequenzbereich von mindestens 20 MHz, bevorzugt mindestens 50 MHz, insbesondere 70 MHz oder größer. Dies hat den Vorteil, dass, je nach Bandbreite, auch eine Pulsweitenmodulation (PWM) des Eingangssignals möglich ist. Insbesondere bei Frequenzen größer als 20 MHz ist ein Anpassnetzwerk bevorzugt.

Bevorzugt ist das Anpassnetzwerk bei einem bekannten bestimmungsgemäßen Eingangssignal bis mindestens zu dessen 3. Harmonischen, besonders bevorzugt sogar bis zu dessen 10. Harmonischen, ausgelegt. Dies hat den Vorteil, dass die Treibervorrichtung den Leistungsschalter (z.B. den Schalttransistor) auch bei Signalen mit einem großen hochfrequenten Anteil reflexionsfrei schalten kann.

Eine bevorzugte Treibervorrichtung umfasst eine Anzahl von Schwingbremsen, welche zur Reduktion von Schwingungen innerhalb der Kaskodenschaltung oder zwischen Kaskodenschaltung und einer der Schnittstellen ausgelegt ist. Diese Schwingbremsen umfassen bevorzugt eine Reihenschaltung aus einem ohmschen Widerstand R und einer Kapazität C (RC-Schwingbremse) oder eine Reihenschaltung aus einer Induktivität L und einer Kapazität C (LC-Schwingbremse). Die Kapazitäten sollten in Hinblick an die Anpassung an die einzelnen Bauelemente der Vorrichtung (z.B. den Transistoren) möglichst geringe Toleranzen haben.

Eine Schwingbremse ist bevorzugt so angeordnet, dass sie Schwingungen zwischen der Emitterstufe und der Basisstufe der Kaskodenschaltung reduziert. Dies kann z.B. dadurch erreicht werden, dass ein Pol der Schwingbremse an der Verbindung zwischen Emitterstufe und Basisstufe der Kaskode angreift und mit dem anderen Pol an dem Bezugspotential.

Alternativ oder ergänzend ist eine Schwingbremse bevorzugt so angeordnet, dass sie Schwingungen zwischen der Kaskodenschaltung und der Ausgangsschnittstelle reduziert. Dies kann z.B. dadurch erreicht werden, dass ein Pol der Schwingbremse am Ausgang der Basisstufe der Kaskode angreift und mit dem anderen Pol an dem Bezugspotential.

Bevorzugt ist eine Schwingbremse zwischen Kaskode und einem Anpassnetzwerk angeordnet.

Eine Schwingbremse ist bevorzugt (insbesondere für ein rechteckförmiges Eingangssignal) breitbandig ausgelegt. Der Ausdruck "breitbandig" umfasst hier einen Frequenzbereich von mindestens 20 MHz, bevorzugt mindestens 50 MHz, insbesondere 70 MHz oder größer.

Untersuchungen haben gezeigt, dass die Stabilitätsgrenze bei GaN Transistoren als Leistungsschalter im Bereich von 100 MHz überschritten werden kann. Dies hat ab einer Frequenz oberhalb der Stabilitätsgrenze Schwingungen zur Folge, die mittels einer Schwingbremse vorteilhaft beseitigt werden können.

Eine bevorzugte Treibervorrichtung umfasst eine Emitterfolgeschaltung in Reihe zwischen Kaskodenschaltung und Ausgangsschnittstelle. Die Emitterschaltung dient zur Verstärkung des Eingangssignals und einer Erhöhung der Bandbreite.

Die Emitterfolgeschaltung ist bevorzugt als komplementärer Emitterfolger ausgestaltet. Dies heißt, dass ein NPN-Transistor und ein PNP-Transistor mit ihrer jeweiligen Basis miteinander zu einer gemeinsamen Basis verbunden sind und mit ihren jeweiligen Emittern ebenfalls zu einem gemeinsamen Emitter verbunden sind. Die gemeinsame Basis ist mit der Kaskode verbunden, der gemeinsame Emitter mit der Ausgangsschnittstelle. Bei einer Verwendung von FETs für die Emitterfolgerschaltung entspricht das Gate der Basis und die Source dem Emitter.

Die Transitfrequenz eines Transistors der Emitterfolgerschaltung sollte wesentlich über den Harmonischen des Eingangssignals liegen. Ein Vorteil der Emitterfolgerschaltung ist eine Reduzierung der thermischen Verluste. Zudem ermöglicht die Emitterfolgerschaltung eine Stromverstärkung und reduziert somit Verluste innerhalb der Kaskodenschaltung.

Die Emitterfolgeschaltung kann von der Treiberspannung versorgt werden, kann aber auch ihre eigene Spannungsversorgung aufweisen.

Bevorzugt ist die Emitterfolgerschaltung mit mindestens einem Anpassnetzwerk vor (zur Kaskode hin) und/oder hinter (zur Ausgangsschnittstelle hin) der Emitterfolgerschaltung in Reihe geschaltet.

Durch Ruheströme sowie durch das verstärkte Eingangssignal ergeben sich thermische Verluste innerhalb der Kaskode. Die Ruheströme sind für die Ansteuerung der richtigen Arbeitspunkte im Kennlinienfeld der Transistoren bevorzugt.

Eine bevorzugte Treibervorrichtung umfasst zwei oder mehr Kaskodenschaltungen in Form einer Parallelschaltung. Dies hat den Vorteil, dass eine Aufteilung der Treiberleistung stattfindet und somit die thermische Belastung für jede Schaltung reduziert wird.

Es hat sich gezeigt, dass die thermischen Verluste hauptsächlich in der Basisschaltung der Kaskode entstehen.

Gemäß einer bevorzugten Treibervorrichtung umfasst die Kaskodenschaltung mindestens zwei Basisstufen, welche zueinander parallel geschaltet sind. Durch die Parallelschaltung der einzelnen Basisstufen können die thermischen Verluste auf die einzelnen Stufen verteilt werden.

Es können auch zwei oder mehr Kaskoden parallel geschaltet werden, wobei eine Anzahl der Kaskoden zwei oder mehr parallel geschaltete Basisstufen umfasst.

Bevorzugt sind dabei die Eingangswiderstände der Basisstufen im Wesentlichen gleich. Es hat sich gezeigt, dass der Eingangswiderstand der Basisschaltung für eine symmetrische Stromaufteilung nicht stark voneinander variieren sollten. Bei starken Variationen des Eingangswiderstandes kommt es zu ungleichen Leistungsverteilungen der Gesamtschaltung. Eine Halbierung des Stromes in zwei Basisstufen führt zur Vierteilung der Leistung. Somit kann z.B. der Transistor der Basisstufe entsprecht kleiner gewählt bzw. die thermischen Effekte deutlich reduziert werden.

Bei einem bevorzugten Herstellungsverfahren wird ein Steuereingang der Basisstufe mit einer spannungsdefinierenden Schaltung versehen, die dazu ausgestaltet ist, dass die Basisstufe bei bestimmungsgemäßem Betrieb der Treibervorrichtung auf einer Spannung geführt wird, die im linearen Bereich der Basisstufe liegt.

Im Falle von Transistoren ist der Steuereingang die Basis (Bipolartransistor) bzw. das Gate (FET). Die spannungsdefinierende Schaltung kann in einem einfachen Fall ein Spannungsteiler sein, der so dimensioniert ist, dass die Spannung am Steuereingang der Basisstufe bei einem bestimmungsgemäßen Betrieb der Treibervorrichtung auf den linearen Bereich des betreffenden Transistors eingestellt ist.

Bei einer bevorzugten Schaltvorrichtung ist der Leistungsschalter ein Leistungstransistor, bevorzugt ein Feldeffekttransistor dessen Gate der Ausgangsschnittstelle der Treibervorrichtung verbunden ist. Besonders bevorzugt sind dabei Feldeffekttransistoren auf der Basis von Galliumnitrid (GaN) oder Siliziumcarbid (SiC).

Bevorzugt wird bei dem Schaltverfahren als Signal ein Rechtecksignal appliziert.

Bevorzugt wird in dem Fall, dass die Treibervorrichtung eine Emitterfolgerschaltung in Reihe zwischen Kaskodenschaltung und Ausgangsschnittstelle umfasst bei dem Schaltverfahren die Emitterfolgerschaltung im linearen Bereich betrieben. Dies hat den Vorteil, dass minimale Verzögerungszeiten und hohe Transitfrequenzen erreicht werden können.

Die Erfindung wird im Folgenden unter Hinweis auf die beigefügten Figuren anhand von Ausführungsbeispielen noch einmal näher erläutert. Dabei sind in den verschiedenen Figuren gleiche Komponenten mit identischen Bezugsziffern versehen. Die Figuren sind in der Regel nicht maßstäblich. Es zeigen:
Figur 1 eine schematische Darstellung eines Ausführungsbeispiels einer erfindungsgemäßen Schaltvorrichtung,
Figur 2 eine schematische Darstellung eines weiteren Ausführungsbeispiels einer erfindungsgemäßen Schaltvorrichtung,
Figur 3 eine schematische Darstellung eines Ausführungsbeispiels einer erfindungsgemäßen Treibervorrichtung,
Figur 4 eine schematische Darstellung eines weiteren Ausführungsbeispiels einer erfindungsgemäßen Treibervorrichtung.

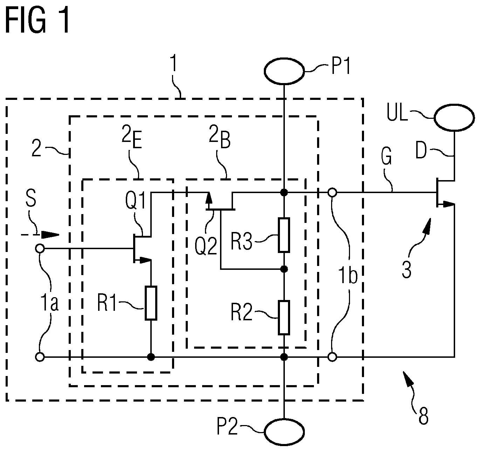

Figur 1 zeigt eine schematische Darstellung eines Ausführungsbeispiels einer erfindungsgemäßen Schaltvorrichtung 8 mit einer Treibervorrichtung 1 und einem Leistungsschalter 3, der im hier dargestellten Fall ein Leistungs-FET ist.

Links ist eine Signalschnittstelle 1a dargestellt, die zwei Pole aufweist. Der obere dient zur Eingabe des Eingangssignals S und ist direkt mit dem Eingang der Kaskodenschaltung 2 verbunden. Der Untere dient zur Kontaktierung mit dem Bezugspotential P2.

Auf die Signalschnittstelle 1a folgt die Kaskodenschaltung 2 mit einer Emitterstufe (2_{E}) und einer Basisstufe (2_{B}). Die Kaskodenschaltung 2 ist hier mit Feldeffekttransistoren Q1, Q2 (FETs) aufgebaut. Ein an der Signalschnittstelle 1a anliegendes Eingangssignal S geht in das Gate des FET Q1 der Emitterstufe 2_{E} ein und wird durch die Kaskode 2 verstärkt. Die Basisstufe 2_{B} ist mit der Ausgangsschnittstelle 1b verschaltet und gibt das verstärkte Einganssignal an diese weiter.

Die Ausgangsschnittstelle 1b hat genau wie die Signalschnittstelle 1a zwei Anschlüsse, von denen der obere wie dargestellt mit dem Schalteingang G eines Leistungsschalters 3 (hier ein FET) verbunden ist und der untere mit dem Bezugspotential P2.

Zum Betrieb der Treibervorrichtung ist diese an ein Treiberpotential P1 und an ein Bezugspotential P2 angeschlossen. Die Differenz zwischen dem Treiberpotential P1 und dem Bezugspotential P2 ergibt die Treiberspannung.

Zur Einstellung des Arbeitspunktes der Kaskodenschaltung werden die Arbeitspunkte der FET Q1, Q2 mittels Widerständen R1, R2, R3 und der Treiberspannung definiert. Beispielsweise ist hier ein Spannungsteiler mit dem Gate des FET Q2 der Basisstufe 2_{B} verbunden und definiert dessen Eingangsspannung.

Der Leistungsschalter 3 ist mit seinem Spannungseingang D an eine Schaltspannung UL angeschlossen, die hier beispielsweise 600 V beträgt.

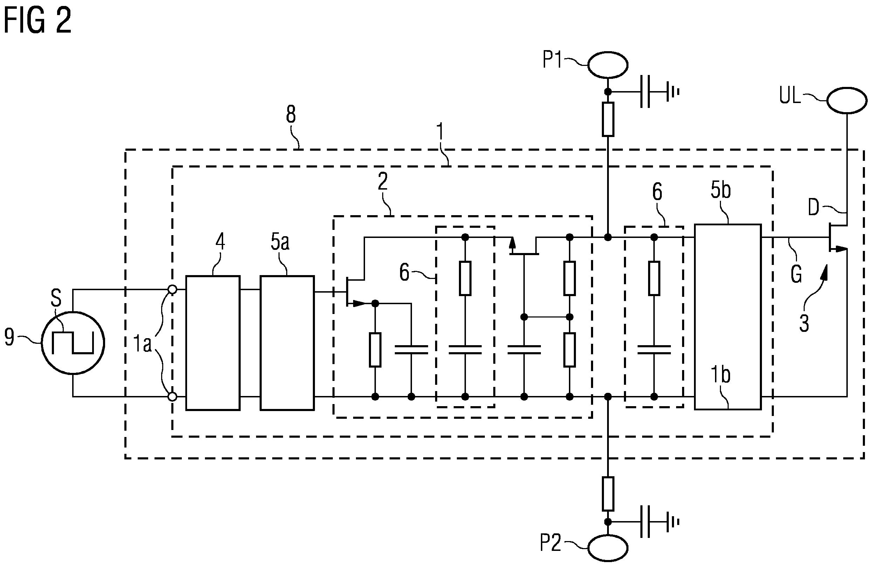

Figur 2 zeigt eine schematische Darstellung eines weiteren Ausführungsbeispiels einer erfindungsgemäßen Schaltvorrichtung 8, welche die in Figur 1 gezeigte schematische Schaltung erweitert.

An die Signalschnittstelle 1a ist in diesem Beispiel ein Signalerzeuger 9 angeschlossen, der ein Rechtecksignal als Eingangssignal S erzeugt.

Dieses Eingangssignal S geht durch die Isolatoreinheit 4 galvanisch entkoppelt in die Kaskodenschaltung 2 ein. Die Anpassung der Impedanz zwischen Isolatoreinheit 4 und Kaskodenschaltung 2 wird durch ein erstes Anpassnetzwerk 5a erreicht.

Die Kaskodenschaltung 2 selber gleicht der in Figur 1 dargestellten Kaskode 2, mit dem Unterschied, dass sie zwischen ihren beiden Stufen eine Schwingbremse 6 enthält. Eine weitere Schwingbremse 6 ist am Ausgang der Kaskodenschaltung 2 angeordnet. In diesem Beispiel sind die beiden Schwingbremsen 6 identisch aufgebaut, in der Regel werden die Kennwerte der verwendeten Schwingbremsen 6 jedoch voneinander abweichen.

Es ist in dieser Figur mittels Schaltzeichen von Widerständen und Kondensatoren an der Kaskodenschaltung 2 und den Zuführungen der Potentiale P1, P2 angedeutet, dass auch dort eine Unterdrückung von Schwingungen stattfinden kann.

Über ein zweites Anpassnetzwerk 5b ist die Treibervorrichtung 1 mit dem Leistungsschalter 3 verbunden. In dem hier gezeigten Fall sind Treibervorrichtung 1 und Leistungsschalter 3 fest miteinander über Leiterbahnen verbunden und das zweite Anpassnetzwerk 5b dient gleichzeitig als Ausgangsschnittstelle 1b.

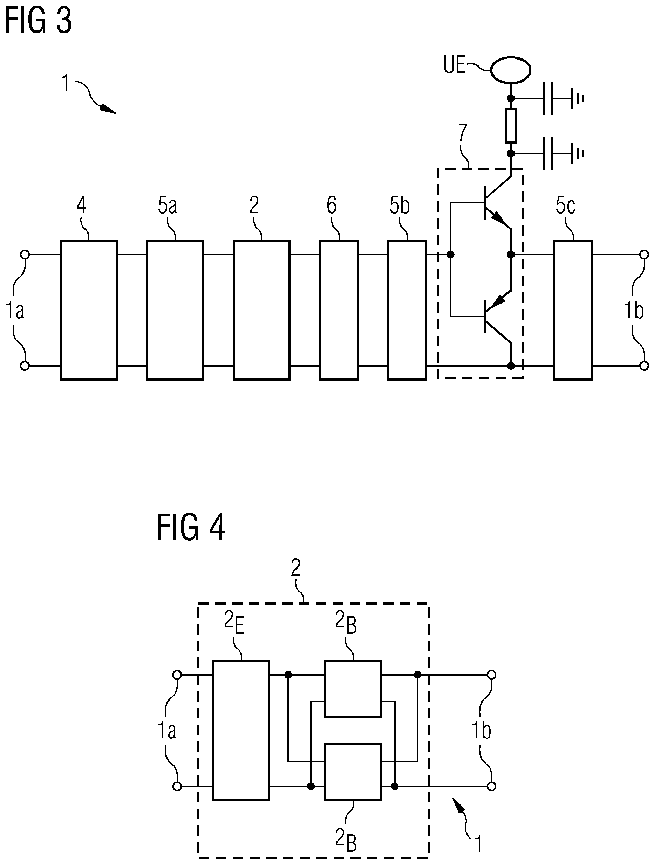

Figur 3 zeigt eine schematische Darstellung eines Ausführungsbeispiels einer erfindungsgemäßen Treibervorrichtung 1 mit einer Emitterfolgerschaltung 7. Die einzelnen Elemente sind hier zur besseren Übersicht als einfache Blöcke dargestellt. Hier kann jedoch einfach der interne Aufbau der einzelnen Blöcke gemäß Figur 2 verwendet werden. Auch ist hier die Spannungsversorgung der Treibervorrichtung 1 nicht explizit dargestellt. Auch hierzu wird auf Figur 2 verwiesen.

Im Grunde ist ein Aufbau der Treibervorrichtung gemäß Figur 2 dargestellt mit dem Unterschied, dass zwischen dem zweiten Anpassnetzwerk 5b und der Ausgangsschnittstelle 1b die Emitterfolgerschaltung 7 zusammen mit einem weiteren Anpassnetzwerk 5c eingefügt worden ist. Die Emitterfolgerschaltung 7 kann zwar mit der Treiberspannung P1, P2 versorgt werden, in dem hier dargestellten Fall hat sie jedoch eine eigene Spannungsversorgung UE.

Die Emitterfolgerschaltung 7 ist für die Stromverstärkung der Treibervorrichtung 1 zuständig und reduziert somit Verluste innerhalb der Kaskodenschaltung 2.

Figur 4 zeigt eine schematische Darstellung eines weiteren Ausführungsbeispiels einer erfindungsgemäßen Treibervorrichtung 1. Die Treibervorrichtung ist ähnlich der in Figur 1 gezeigten aufgebaut, nur dass hier zur besseren Übersicht die einzelnen Elemente (Emitterstufe 2_{E} und Basisstufen 2_{B}) als einfache Blöcke ohne Andeutung der inneren Struktur dargestellt sind. Auch ist die Spannungsversorgung hier nicht explizit dargestellt.

Im Unterschied zu Figur 1 umfasst die Kaskodenschaltung 2 hier zwei identische Basisstufen 1_{B}, welche zueinander parallel geschaltet sind.

Es wird abschließend noch einmal darauf hingewiesen, dass es sich bei den vorhergehend detailliert beschriebenen Vorrichtungen lediglich um Ausführungsbeispiele handelt, welche vom Fachmann in verschiedenster Weise modifiziert werden können, ohne den Bereich der Erfindung zu verlassen. Weiterhin schließt die Verwendung der unbestimmten Artikel "ein" bzw. "eine" nicht aus, dass die betreffenden Merkmale auch mehrfach vorhanden sein können. Ebenso schließen die Begriffe "Einheit" und "Vorrichtung" o.ä. nicht aus, dass die betreffenden Komponenten aus mehreren zusammenwirkenden TeilKomponenten bestehen, die gegebenenfalls auch räumlich verteilt sein können.

## Patentansprüche

1. Treibervorrichtung (1) zur Schaltung eines Leistungsschalters (3) umfassend:
- eine Signalschnittstelle (1a) ausgelegt für den Empfang eines Eingangssignals (S),
- eine Ausgangsschnittstelle (1b) ausgelegt für eine elektrisch leitfähige Verbindung mit dem Schalteingang (G) eines Leistungsschalters (3),
- eine Kaskodenschaltung (2) mit einer Emitterstufe (2_{E}) und einer Basisstufe (2_{B}), wobei die Emitterstufe (2_{E}) mit der Signalschnittstelle (1a) verschaltet ist und die Basisstufe (2_{B}) mit der Ausgangsschnittstelle (1b) verschaltet ist, und
- einen Spannungsregulator, der dazu ausgestaltet ist, die Kaskodenschaltung (2) im linearen Bereich zu betreiben, wobei ein Spannungsteiler (R1,R2) vorgesehen ist, der so dimensioniert ist, dass die Spannung an einem Steuereingang der Basisstufe bei einem bestimmungsgemäßen Betrieb der Treibervorrichtung auf den linearen Bereich des Transistors der Basisstufe eingestellt ist.

2. Treibervorrichtung nach einem der vorangehenden Ansprüche, wobei die Signalschnittstelle (1a) mittels einer Isolatoreinheit (4) mit der Kaskodenschaltung (2) verbunden ist, wobei die Isolatoreinheit (4) zu einer galvanischen Trennung der Signalschnittstelle (1a) und der Kaskodenschaltung (2) ausgelegt ist und
die Isolatoreinheit (4) bevorzugt einen kapazitiven Koppler, einen Optokoppler oder einen Transformator umfasst.

3. Treibervorrichtung nach einem der vorangehenden Ansprüche, wobei zwischen Signalschnittstelle (1a) und Kaskodenschaltung (2) und/oder zwischen Kaskodenschaltung (2) und Ausgangsschnittstelle (1b) ein Anpassnetzwerk (5a, 5b) angeordnet ist, welche zu einer Anpassung von Impedanzen zwischen der Kaskodenschaltung (2) und der betreffenden Schnittstelle (1a, 1b) ausgelegt ist.

4. Treibervorrichtung nach einem der vorangehenden Ansprüche, umfassend eine Anzahl von Schwingbremsen (6), welche zur Reduktion von Schwingungen innerhalb der Kaskodenschaltung (2) oder zwischen Kaskodenschaltung (2) und einer der Schnittstellen (1a, 1b) ausgelegt ist,
wobei eine Schwingbremse (6) bevorzugt so angeordnet ist, dass sie Schwingungen zwischen der Emitterstufe (1_{E}) und der Basisstufe (1_{B}) der Kaskodenschaltung (2) reduziert und/oder wobei eine Schwingbremse (6) bevorzugt so angeordnet ist, dass sie Schwingungen zwischen der Kaskodenschaltung (2) und der Ausgangsschnittstelle (1b) reduziert.

5. Treibervorrichtung nach einem der vorangehenden Ansprüche, umfassend eine Emitterfolgeschaltung (7) in Reihe zwischen Kaskodenschaltung (2) und Ausgangsschnittstelle (1b), wobei die Emitterfolgeschaltung (7) bevorzugt als komplementärer Emitterfolger ausgestaltet ist.

6. Treibervorrichtung nach einem der vorangehenden Ansprüche, umfassend zwei oder mehr Kaskodenschaltungen (2) in Form einer Parallelschaltung.

7. Treibervorrichtung nach einem der vorangehenden Ansprüche, wobei die Kaskodenschaltung (2) mindestens zwei Basisstufen (1_{B}) umfasst, welche zueinander parallel geschaltet sind, wobei die Eingangswiderstände der Basisstufen (1_{B}) bevorzugt im Wesentlichen gleich sind.

8. Herstellungsverfahren zur Herstellung einer Treibervorrichtung (1) nach einem der Ansprüche 1 bis 7, umfassend die Schritte:
- Bereitstellung einer Signalschnittstelle (1a) ausgelegt für den Empfang eines Eingangssignals (S),
- Bereitstellung einer Ausgangsschnittstelle (1b) ausgelegt für eine elektrisch leitfähige Verbindung mit einem Schalteingang (G) eines Leistungsschalters (3),
- Anordnung einer Kaskodenschaltung (2) mit einer Emitterstufe (2_{E}) und einer Basisstufe (2_{B}), deren Emitterstufe (2_{E}) mit der Signalschnittstelle (1a) verschaltet ist, und deren Basisstufe (2_{B}) mit der Ausgangsschnittstelle (1b) verschaltet ist,
- Anordnung eines Spannungsregulators, der dazu ausgestaltet ist, die Kaskodenschaltung (2) im linearen Bereich zu betreiben, wobei ein Spannungsteiler (R1,R2) vorgese-hen wird, der so dimensioniert ist, dass die Spannung an einem Steuereingang der Basisstufe bei einem bestimmungsgemäßen Betrieb der Treibervorrichtung auf den linearen Bereich des Transistors der Basisstufe eingestellt wird, und
- Leistungsanpassung der Emitterstufe (2_{E}).

9. Schaltvorrichtung (8) zur Leistungsschaltung umfassend einen Leistungsschalter (3) und eine Treibervorrichtung (1) nach einem der Ansprüche 1 bis 7, wobei der Leistungsschalter (3) mit seinem Schalteingang (G) mit der Ausgangsschnittstelle (1b) der Treibervorrichtung (1) verbunden ist.

10. Schaltvorrichtung nach Anspruch 9, wobei der Leistungsschalter (3) ein Leistungstransistor ist, bevorzugt ein Feldeffekttransistor, besonders bevorzugt auf der Basis von Galliumnitrid oder Siliziumcarbid, dessen Gate (G) der Ausgangsschnittstelle (1b) der Treibervorrichtung (1) verbunden ist.

11. Schaltverfahren zur Leistungsschaltung mittels einer Schaltvorrichtung (8) nach Anspruch 9 oder 10, umfassend die Schritte:
- Anlegen einer Schaltspannung (UL) an einen Spannungseingang (D) des Leistungsschalters (3),
- Anlegen einer Treiberspannung (P1, P2) an die Treibervorrichtung (1),
- Applikation eines Eingangssignals (S) an der Signalschnittstelle (1a) der Treibervorrichtung (1) mit einer Frequenz größer als 5 MHz.

12. Schaltverfahren nach Anspruch 11, wobei als Eingangssignal (S) ein Rechtecksignal appliziert wird.

13. Schaltverfahren nach Anspruch 11 oder 12, wobei die Treibervorrichtung (1) eine Emitterfolgerschaltung (7) in Reihe zwischen Kaskodenschaltung (2) und Ausgangsschnittstelle (1b) umfasst, wobei die Emitterfolgerschaltung (7) im linearen Bereich betrieben wird.

## Claims

1. Driver device (1) for switching a circuit breaker (3) comprising:
- a signal interface (1a) designed to receive an input signal (S),
- an output interface (1b) designed for an electrically conductive connection to the switching input (G) of a circuit breaker (3),
- a cascade circuit (2) with an emitter level (2_{E}) and a base level (2_{B}), wherein the emitter level (2_{E}) is interconnected with the signal interface (1a) and the base level (2_{B}) is interconnected with the output interface (1b), and
- a voltage regulator which is configured to operate the cascade circuit (2) in the linear range, wherein a voltage divider (R1, R2) is provided, which is dimensioned such that, during intended operation of the driver device, at a control input of the base level, the voltage is set to the linear range of the transistor of the base level.

2. Driver device according to one of the preceding claims, wherein the signal interface (1a) is connected to the cascade circuit (2) by means of an insulator unit (4), wherein the insulator unit (4) is designed for a galvanic isolation of the signal interface (1a) and the cascade circuit (2) and
the insulator unit (4) preferably comprises a capacitive coupler, an optocoupler or a transformer.

3. Driver device according to one of the preceding claims, wherein a matching network (5a, 5b) is arranged between signal interface (1a) and cascade circuit (2) and/or between cascade circuit (2) and output interface (1b), which is designed to adjust impedances between the cascade circuit (2) and the relevant interface (1a, 1b).

4. Driver device according to one of the preceding claims, comprising a number of shock absorbers (6) which are designed to reduce vibrations within the cascade circuit (2) or between cascade circuit (2) and one of the interfaces (1a, 1b),
wherein a shock absorber (6) is preferably arranged such that it reduces vibrations between the emitter level (1_{E}) and the base level (1_{B}) of the cascade circuit (2) and/or wherein a shock absorber (6) is preferably arranged such that it reduces vibrations between the cascade circuit (2) and the output interface (1b).

5. Driver device according to one of the preceding claims, comprising an emitter follower circuit (7) in series between cascade circuit (2) and output interface (1b), wherein the emitter follower circuit (7) is preferably designed as a complementary emitter follower.

6. Driver device according to one of the preceding claims, comprising two or more cascade circuits (2) in the form of a parallel circuit.

7. Driver device according to one of the preceding claims, wherein the cascade circuit (2) comprises at least two base levels (1_{B}), which are electrically connected in parallel with one another, wherein the input resistances of the base level (1_{B}) are essentially the same.

8. Manufacturing method for manufacturing a driver device (1) according to one of claims 1 to 7, comprising the steps:
- providing a signal interface (1a) designed to receive an input signal (S)
- providing an output interface (1b) designed for an electrically conductive connection to a switching input (G) of a circuit breaker (3),
- arrangement of a cascade circuit (2) with an emitter level (2_{E}) and a base level (2_{B}), the emitter level (2_{E}) of which is interconnected with the signal interface (1a) and the base level (2_{B}) of which is interconnected with the output interface (1b),
- arrangement of a voltage regulator which is configured to operate the cascade circuit (2) in the linear range, wherein a voltage divider (R1, R2) is provided, which is dimensioned such that, during intended operation of the driver device, the voltage is set to the linear range of the transistor of the base level, and
- output matching of the emitter level (2_{E}).

9. Switching device (8) for power switching comprising a circuit breaker (3) and a driver device (1) according to one of claims 1 to 7, wherein the circuit breaker (3) is connected with its switching input (G) to the output interface (1b) of the driver device (1).

10. Switching device according to claim 9, wherein the circuit breaker (3) is a power transistor, preferably a field effect transistor, particularly preferably based on gallium nitride or silicon carbide, the gate (G) of which is connected to the output interface (1b) of the driver device (1).

11. Switching method for power switching by means of a switching device (8) according to claim 9 or 10, comprising the steps:
- applying a switching voltage (UL) to a voltage input (D) of the circuit breaker (3),
- applying a driver voltage (P1, P2) to the driver device (1),
- application of an input signal (S) to the signal interface (1a) of the driver device (1) with a frequency which is greater than 5 MHz.

12. Switching method according to claim 11, wherein a square-wave signal is applied as the input signal (S).

13. Switching method according to claim 11 or 12, wherein the driver device (1) comprises an emitter follower circuit (7) in series between cascade circuit (2) and output interface (1b), wherein the emitter follower circuit (7) is operated in the linear range.

## Revendications

1. Montage (1) pilote de connexion d'un disjoncteur (3) comprenant :
- une interface (1a) de signal conçue pour la réception d'un signal (S) d'entrée,
- une interface (1b) de sortie conçue pour une liaison conductrice de l'électricité avec l'entrée (G) de commande d'un disjoncteur (3),
- un circuit (2) cascode ayant un étage (2_{E}) d'émetteur et un étage (2_{B}) de base, dans lequel l'étage (2_{E}) d'émetteur est connecté à l'interface (1a) de signal et l'étage (2_{B}) de base est connecté à l'interface (1b) de sortie, et
- un régulateur de tension, qui est conformé pour faire fonctionner le circuit (2) cascode dans le domaine linéaire, dans lequel il est prévu un diviseur (R1, R2) de tension, qui a des dimensions telles, que la tension à une entrée de commande de l'étage de base est, dans un fonctionnement conforme aux prescriptions du montage pilote, réglée sur le domaine linéaire du transistor de l'étage de base.

2. Montage pilote suivant l'une des revendications précédentes,
dans lequel l'interface (1a) de signal est reliée au circuit (2) cascode au moyen d'une unité (4) d'isolateur, dans lequel l'unité (4) d'isolateur est conçue pour une séparation galvanique de l'interface (1a) de signal et du circuit (2) de cascode et
l'unité (4) d'isolateur comprend, de préférence, un coupleur capacitif, un optocoupleur ou un transformateur.

3. Montage pilote suivant l'une des revendications précédentes, dans lequel entre l'interface (1a) de signal et le circuit (2) cascode et/ou entre le circuit (2) cascode et l'interface (1b) de sortie est disposé un réseau (5a, 5b) d'adaptation, qui est conçu pour une adaptation d'impédance entre le circuit (2) cascode et l'interface (1a, 1b) concernée.

4. Montage pilote suivant l'une des revendications précédentes, comprenant un nombre de freins (6) d'oscillation, qui est conçu pour la réduction d'oscillations dans le circuit (2) cascode ou entre le circuit (2) cascode et l'une des interfaces (1a, 1b),
dans lequel un frein (6) d'oscillation est monté, de préférence, de manière à réduire des oscillations entre l'étage (1_{E}) d'émetteur et l'étage (1_{B}) de base du circuit (2) cascode et/ou dans lequel un frein (6) d'oscillation est monté, de préférence, de manière à réduire des oscillations entre le circuit (2) cascode et l'interface (1b) de sortie.

5. Montage pilote suivant l'une des revendications précédentes, comprenant un circuit (7) suiveur émetteur en série entre le circuit (2) cascode et l'interface (1b) de sortie, le circuit (7) suiveur émetteur étant conformé de préférence, sous la forme d'un suiveur émetteur complémentaire.

6. Montage pilote suivant l'une des revendications précédentes, comprenant deux ou plusieurs circuits (2) cascode sous la forme d'un circuit en parallèle.

7. Montage pilote suivant l'une des revendications précédentes, dans lequel le circuit (2) cascode comprend au moins deux étages (1_{B}) de base, qui sont montés en parallèle entre eux, dans lequel les résistances d'entrée des étages (1_{B}) de base sont, de préférence, sensiblement égales.

8. Procédé de fabrication pour la fabrication d'un montage (1) pilote suivant l'une des revendications 1 à 7, comprenant les stades :
- on se procure une interface (1a) de signal conçue pour la réception d'un signal (S) d'entrée,
- on se procure une interface (1b) de sortie conçue pour une liaison conductrice de l'électricité avec une entrée (G) de commande d'un disjoncteur (3),
- on monte un circuit (2) cascode ayant un étage (2_{E}) d'émetteur et un étage (2_{B}) de base, dont l'étage (2_{E}) d'émetteur est connecté à l'interface (1a) de signal et dont l'étage (2_{B}) de base est connecté à l'interface (1b) de sortie,
- on monte un régulateur de tension, qui est conformé, de manière à faire fonctionner le circuit (2) cascode dans le domaine linéaire, dans lequel on prévoit un diviseur (R1, R2) de tension, qui a des dimensions telles, que la tension a une entrée de commande de l'étage de base est, pour un fonctionnement suivant les prescriptions du montage pilote, réglée sur le domaine linéaire du transistor de l'étage de base, et
- on adapte la puissance de l'étage (2_{E}) émetteur.

9. Montage (8) de coupure pour la connexion de puissance, comprenant un disjoncteur (3) et un montage (1) pilote suivant l'une des revendications 1 à 7, dans lequel le disjoncteur (3) est relié par son entrée (G) de commande à l'interface (1b) de sortie du montage (1) pilote.

10. Montage de coupure suivant la revendication 9, dans lequel le disjoncteur (3) est un transistor de puissance, de préférence un transistor à effet de champ, d'une manière particulièrement préférée à base de nitrure de gallium ou de carbure de silicium, dont la grille (G) est reliée à l'interface (1b) de sortie du montage (1) pilote.

11. Procédé de coupure pour la connexion de puissance, au moyen d'un montage (8) de coupure suivant la revendication 9 ou 10, comprenant les stades :
- on applique une tension (UL) de coupure à une entrée (D) de tension du disjoncteur (3),
- on applique une tension (P1, P2) pilote au montage (1) pilote,
- on applique un signal (S) d'entrée à l'interface (1a) de signal du montage (1) pilote à une fréquence plus grande que 5 MHz.

12. Procédé de coupure suivant la revendication 11, dans lequel on applique un signal rectangulaire comme signal (S) d'entrée.

13. Procédé de coupure suivant la revendication 11 ou 12, dans lequel le montage (1) pilote comprend un circuit (7) suiveur émetteur en série entre le circuit (2) cascode et l'interface (1b) de sortie, dans lequel on fait fonctionner le circuit (7) suiveur émetteur dans le domaine linéaire.
